# EUROPÄISCHE PATENTSCHRIFT

(11) **EP 3 823 304 B1**
(45) Veröffentlichungstag und Bekanntmachung des Hinweises auf die Patenterteilung: **03.04.2024**
(21) Anmeldenummer: 20217912.3
(22) Anmeldetag: 13.05.2015
(51) Int. Cl.: H04R 19/02, H04R 17/00, H04R 17/02, H04R 19/04, H04R 7/18, H04R 19/00

(54) **MEMS-LAUTSPRECHER MIT AKTUATORSTRUKTUR UND DAVON BEABSTANDETER MEMBRAN**
MEMS LOUDSPEAKER WITH ACTUATOR STRUCTURE AND DISTANCED DIAPHRAGM
HAUT-PARLEUR MEMS DOTÉ D'UNE STRUCTURE D'ACTIONNEUR ET D'UNE MEMBRANE ESPACÉE DE CELUI-CI

(30) Priorität: 14.05.2014 DE 102014106753
(43) Veröffentlichungstag der Anmeldung: 19.05.2021
(62) Teilanmeldung aus: 15722531.9
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT)
(74) Vertreter: Canzler & Bergmeier Patentanwälte Partnerschaft mbB

(56) Entgegenhaltungen:
- JP-A- S59 139 799
- US-A1- 2010 219 722
- US-A1- 2013 126 991

## Beschreibung

Die vorliegende Erfindung betrifft einen MEMS-Lautsprecher zum Erzeugen von Schallwellen im hörbaren Wellenlängenspektrum mit einem Trägersubstrat, das einen Substrathohlraum mit zwei Substratöffnungen aufweist, die an zwei gegenüberliegenden Seiten des Trägersubstrats ausgebildet sind, einer Aktuatorstruktur, welche im Bereich einer der beiden Substratöffnungen angeordnet ist und diese überspannt und in ihrem Randbereich mit dem Trägersubstrat verbunden ist, und einer in ihrem Randbereich verankerten Membran, die mittels der Aktuatorstruktur zum Erzeugen von Schallwellen in Schwingung versetzbar ist.

Die Bezeichnung MEMS steht für mikroelektromechanische Systeme. Bei MEMS-Lautsprechern erfolgt die Schallerzeugung über eine schwingbar gelagerte Membran. Die Membran kann über insbesondere piezoelektrische Betätigungsglieder zur Erzeugung einer Schallwelle in Schwingung versetzt werden. Ein derartiger Mikrolautsprecher muss in der Regel eine hohe Luftvolumenverschiebung erzeugen, um einen signifikanten Schalldruckpegel erreichen zu können. Ein derartiger Mikrolautsprecher ist beispielsweise aus der DE 10 2012 220 819 A1, US 2013/0126991 A1 und US 2010/0219722 A1 bekannt.

Aus der JP S59 139799 A ist ein piezoelektrischer Flachlautsprecher bekannt, der mehrere L-förmige piezoelektrische Aktuatoren aufweist, die an einer Unterseite mit einer Membran des Flachlautsprechers verbunden sind. Die L-förmigen piezoelektrischen Aktuatoren sind untereinander mit einem Koppelelement verbunden.

Aus der US 2011/0051985 A1 ist ferner ein Mikrolautsprecher bekannt, der einen piezoelektrischen Aktuatoren und eine Membran umfasst, die auf einem Substrat, das eine Kavität aufweist, angeordnet sind. Der piezoelektrische Aktuator umfasst eine piezoelektrische Schicht, die über eine dazwischengeschaltete Elektrodenschicht vollflächig mit der Membran verbunden ist. Die piezoelektrische Schicht bildet somit zusammen mit der Membran eine mehrschichtige Einheit aus. Hierdurch ist der Gestaltungsfreiraum zur Ausbildung der Membran durch den Aktuator eingeschränkt. Ebenso ist auch der Gestaltungsfreiraum des Aktuators durch die Membran eingeschränkt. So muss die Membran eine bestimmte Größe aufweisen, um eine ausreichend gute akustische Leistung gewährleisten zu können. Auf der anderen Seite muss der Aktuatoren möglichst klein ausgebildet werden, um die Kosten des MEMS-Lautsprechers gering halten zu können. Bei aus dem Stand der Technik bekannten MEMS-Lautsprechern wirkt sich jedoch eine optimierte Ausgestaltung einer dieser beiden Komponenten stets nachteilig in Bezug auf die andere Komponente aus.

Aufgabe der vorliegenden Erfindung ist es somit, einen MEMS-Lautsprecher zu schaffen, der kostengünstig herstellbar ist und eine verbesserte akustische Leistung aufweist.

Die Aufgabe wird gelöst durch einen MEMS-Lautsprecher mit den Merkmalen des unabhängigen Patentanspruchs 1.

Vorgeschlagen wird ein MEMS-Lautsprecher zum Erzeugen von Schallwellen im hörbaren Wellenlängenspektrum. Der MEMS-Lautsprecher weist ein Trägersubstrat auf. Dieses ist vorzugsweise aus Silizium ausgebildet. Das Trägersubstrat weist einen Substrathohlraum mit zwei Substratöffnungen auf. Die beiden Substratöffnungen sind an zwei gegenüberliegenden Seiten, insbesondere Stirnflächen, des Trägersubstrats ausgebildet. Das Trägersubstrat ist somit vorzugsweise als ein umfangsmäßig geschlossener Trägerrahmen ausgebildet. Des Weiteren umfasst der MEMS-Lautsprecher eine, insbesondere piezoelektrische, Aktuatorstruktur. Die Aktuatorstruktur ist vorzugsweise mehrschichtig ausgebildet, wobei diese zumindest eine, insbesondere piezoelektrische, Aktuatorschicht, eine Elektrodenschicht und/oder eine Trägerschicht umfasst. Die Aktuatorschicht und/oder die Elektrodenschicht ist vorzugsweise bereichsweise ausgespart. Die Aktuatorstruktur ist im Bereich einer der beiden Substratöffnungen angeordnet. In ihrem Randbereich ist die Aktuatorstruktur mit dem Trägersubstrat, insbesondere an einer der Stirnfläche des Trägersubstrats, verbunden. Vorzugsweise überspannt die Aktuatorstruktur, insbesondere ihre Trägerschicht, die Substratöffnung vollflächig. Die Substratöffnung ist in diesem Fall mittels der Aktuatorstruktur vorzugsweise vollständig geschlossen. Außerdem umfasst der MEMS-Lautsprecher eine Membran. Die Membran ist vorzugsweise aus einem Elastomer, insbesondere Silikon, ausgebildet. Die Membran ist in ihrem, insbesondere gesamten, Randbereich verankert. Die Membran ist mittels der Aktuatorstruktur zum Erzeugen von Schallwellen in Schwingung versetzbar, so dass sie gegenüber ihrem Verankerungsbereich zu schwingen vermag.

In einer Querschnittsansicht des MEMS-Lautsprechers ist die Membran von der Aktuatorstruktur beabstandet. Zwischen diesen beiden ist somit ein Zwischenhohlraum ausgebildet. Die Membran und die Aktuatorstruktur sind somit räumlich voneinander entkoppelt. Des Weiteren weist der MEMS-Lautsprecher ein Koppelelement auf. Das Koppelelement ist in dem Zwischenhohlraum angeordnet. Des Weiteren verbindet das Koppelelement die Aktuatorstruktur mit der Membran, insbesondere bereichsweise. Die Membran und die Aktuatorstruktur sind somit mittels des Koppelelementes mechanisch miteinander gekoppelt. Bei elektrischer Anregung der Aktuatorstruktur schwingt das Koppelelement infolgedessen zusammen mit der Membran und der Aktuatorstruktur gegenüber dem Trägersubstrat. Vorteilhafterweise können die Membran und die Aktuatorstruktur im Wesentlichen unabhängig voneinander, insbesondere geometrisch in Bezug auf ihre jeweilige Größe, optimiert werden, ohne dass hierdurch die Eigenschaften des anderen Bauteils negativ beeinflusst werden. Demnach kann beispielsweise die Aktuatorstruktur im Vergleich zur Membran kleiner ausgebildet werden, wodurch die Materialkosten des MEMS-Lautsprechers reduzierbar sind. Zugleich kann die Membran möglichst groß, insbesondere größer als die Aktuatorstruktur, ausgebildet werden, wodurch wiederum die Performance - d.h. die akustische Leistungsfähigkeit - des MEMS-Lautsprechers erhöht werden kann.

Trotz dieser räumlichen Beabstandung bzw. räumlichen Entkopplung der Membran von der Aktuatorstruktur sind diese mittels des Koppelelementes dennoch, insbesondere in zumindest einem Bereich, miteinander gekoppelt, so dass die Membran über die Aktuatorstruktur angesteuert werden kann. Vorteilhafterweise kann der MEMS-Lautsprecher hierdurch bei einer Auslegung hinsichtlich einer optimalen Performance zugleich dennoch sehr kostengünstig ausgebildet werden.

Vorteilhaft ist es, wenn die Membran, insbesondere zusammen mit der Aktuatorstruktur und dem Koppelelement, bei aktiver Aktuatorstruktur aus einer, insbesondere horizontalen, Neutralstellung auslenkbar ist. In dieser Neutralstellung sind die Membran und/oder die Aktuatorstruktur im Wesentlichen horizontal ausgerichtet und/oder ungekrümmt. Vorzugsweise ist die Membran mit einer Elongation von mehr als 200 % auslenkbar. Aufgrund der hohen Elongation kann vorteilhafterweise ein sehr hoher Schalldruck erzeugt werden.

Zur Verbesserung der akustische Leistungsfähigkeit des MEMS-Lautsprechers und um diesen vor einer Beschädigung bei Stößen zu schützen, ist es vorteilhaft, wenn die Aktuatorstruktur derart, insbesondere steif, ausgebildet ist, dass die Membran bei inaktiver Aktuatorstruktur nach ihrer Auslenkung mittels der Aktuatorstruktur wieder in die Neutralstellung zurückführbar und/oder in der Neutralstellung haltbar ist. Die Aktuatorstruktur übernimmt somit die Aufgaben einer Spinne, wie sie von gewöhnlichen großen Lautsprechern bekannt ist. Die Aktuatorstruktur wirkt somit zusätzlich - neben der Ansteuerbarkeit der Membran - in ihrem inaktiven Zustand zusätzlich als Dämpfer, um die Membran bei Stößen weitestgehend in ihrer Neutralstellung zu halten. Des Weiteren führt die Aktuatorstruktur die Membran nach ihrer Auslenkung wieder in ihre Neutralstellung zurück, so dass hierdurch bei einer erneuten Ansteuerung die Leistungsfähigkeit des MEMS-Lautsprechers nicht beeinflusst wird.

Um einen möglichst hohen Schalldruck erzeugen zu können, muss sich die Membran möglichst weit ausdehnen bzw. schwingen können. Aufgrund dessen ist es vorteilhaft, wenn die Membran eine Dicke von weniger als 0,3 mm und/oder einen E-Modul von weniger als 100 MPa aufweist.

Um ein Reißen der Membran vermeiden zu können, ist es vorteilhaft, wenn die Membran zumindest einen verdickten Verstärkungsbereich aufweist. Zusätzlich oder alternativ ist es aus selbigem Grund vorteilhaft, wenn die Membran zumindest ein Verstärkungselement umfasst, das vorzugsweise an ihrer dem Koppelelement abgewandten Seite angeordnet ist. Das Verstärkungselement ist vorzugsweise aus einem Metall oder einer Metalllegierung - insbesondere Aluminium und/oder Aluminiumnitrid - Silizium, Kunststoff und/oder einem Verbundwerkstoff - insbesondere mit Carbonfasern - ausgebildet. Das Verstärkungselement verhindert ein Reißen der sehr flexiblen Membran.

Um die Flexibilität und die Auslenkbarkeit der Membran zu verbessern, ist es vorteilhaft, wenn diese einen Bereich mit, insbesondere wellenförmigen, Erhebungen aufweist. Dieser Bereich ist vorzugsweise benachbart zu ihrem Befestigungsbereich angeordnet.

Vorteilhaft ist es, wenn die Aktuatorstruktur und die Membran in der Neutralstellung zueinander parallel ausgerichtet sind. Des Weiteren ist es vorteilhaft, wenn die maximale Höhe des Koppelelementes dem in der Neutralstellung, insbesondere kürzesten, Abstand zwischen der Aktuatorstruktur und der Membran entspricht. Hierdurch kann die Membran und die Aktuatorstruktur miteinander gekoppelt werden, ohne dass ihre, insbesondere horizontale und/oder zueinander parallele, Neutralstellung mittels des Koppelelementes beeinflusst wird.

Auch ist es vorteilhaft, wenn die Membran im Bereich der anderen Substratöffnung, d.h. insbesondere an der der Aktuatorstruktur gegenüberliegenden Stirnfläche des Trägersubstrats, angeordnet ist, diese Substratöffnung überspannt und/oder in ihrem Randbereich mit dem Trägersubstrat verbunden ist. Die Membran ist vorzugsweise in ihrem Randbereich an einer der Aktuatorstruktur abgewandten Fläche, insbesondere Stirnseite, des Trägersubstrats, verbunden. Hierbei kann die Membran auf das Trägersubstrat aufgeklebt sein. Vorteilhafterweise ist die Membran somit unmittelbar an dem Trägersubstrat verankert. Der Substratträger, die Aktuatorstruktur, die Membran und das Koppelelement bilden somit eine Baueinheit mit aufgehängter Membran, die beispielsweise flexibel in oder mit unterschiedlichen Leiterplatten verbindbar ist.

Vorteilhaft ist es, wenn der MEMS-Lautsprecher eine Leiterplatte, insbesondere ein PCB (printed circuit board) umfasst. Die Leiterplatte weist des Weiteren vorzugsweise einen ersten Leiterplattenhohlraum auf, in dem das Trägersubstrat, die Aktuatorstruktur und/oder die Membran derart angeordnet sind, dass die Aktuatorstruktur und die Membran gegenüber der Leiterplatte zu schwingen vermögen. Durch eine derart eingebettete Aktuatorstruktur und/oder Membran kann der MEMS-Lautsprecher sehr kompakt ausgebildet werden, da die Dicke der Leiterplatte zur Anordnung zumindest einer der vorstehend genannten Komponenten sowie zur Ausbildung einer Kavität genutzt werden kann.

In einer vorteilhaften Weiterbildung der Erfindung weist der erste Leiterplattenhohlraum einen ersten Bereich, insbesondere einen Kavitätsbereich, auf, der zumindest teilweise die Kavität des MEMS-Lautsprechers ausbildet. Zusätzlich oder alternativ weist der erste Leiterplattenhohlraum einen, insbesondere zum ersten Bereich benachbarten, zweiten Bereich, insbesondere einen Substrataufnahmebereich, auf, indem das Trägersubstrat angeordnet ist. Vorzugsweise ist der erste Leiterplattenhohlraum in seinem zweiten Bereich breiter ausgebildet als in seinem ersten Bereich. Hierdurch weist der erste Leiterplattenhohlraum einen zwischen dem ersten und zweiten Bereich ausgebildeten Absatz bzw. eine Stufe auf. Vorteilhafterweise ist das Trägersubstrat somit zumindest in einer Richtung formschlüssig in der Leiterplatte gehalten. Des Weiteren kann die exakte Position des Trägersubstrats in der Leiterplatte hierdurch festgelegt werden. Zusätzlich kann das Trägersubstrat mit der Leiterplatte, insbesondere im Stufenbereich, verklebt sein. Zusätzlich oder alternativ ist es ebenso auch denkbar, dass die Leiterplatte derart schichtweise aufgebaut ist, dass der erste Leiterplattenhohlraum eine Hinterschneidung aufweist, so dass das Trägersubstrat auch in eine zweite Richtung formschlüssig gehalten ist. Das Trägersubstrat ist somit, insbesondere in seinem Randbereich, von der Leiterplatte formschlüssig umgriffen.

Vorteilhaft ist es, wenn die Membran in einer Querschnittsansicht des MEMS-Lautsprechers vom Trägersubstrat beabstandet ist. Hierdurch ist die geometrische Ausgestaltung der Membran, insbesondere deren flächenmäßige Ausbreitung, nicht auf die geometrischen Abmaße des Trägersubstrats beschränkt. Dadurch, dass die Membran vom Trägersubstrat entkoppelt ist, kann das Trägersubstrat vorteilhafterweise kleiner als die Membran ausgebildet werden. Hierdurch kann Material, insbesondere Silizium, des Trägersubstrats eingespart werden, wodurch der MEMS-Lautsprecher günstiger hergestellt werden kann. Zugleich kann die Membran sehr groß ausgebildet werden, wodurch die akustische Leistungsfähigkeit des MEMS-Lautsprechers vergrößert werden kann.

Diesbezüglich ist es ferner vorteilhaft, wenn die Membran in ihrem Randbereich mit der Leiterplatte, insbesondere an einer Stirnseite der Leiterplatte oder an einer Seitenwand des ersten Leiterplattenhohlraums, verbunden ist. Wenn die Membran an der Stirnseite der Leiterplatte befestigt ist, insbesondere mit dieser verklebt ist, erstreckt sich die Membran vorzugsweise, insbesondere vollflächig, über eine Schallaustrittsöffnung des ersten Leiterplattenhohlraums. Wenn die Membran alternativ dazu an einer Seitenwand des ersten Leiterplattenhohlraums - d.h. im Inneren des ersten Leiterplattenhohlraums - befestigt ist, erstreckt sich diese, insbesondere vollflächig, zumindest über die gesamte Breite des ersten Leiterplattenhohlraums in dessen entsprechenden Bereich. Der Randbereich der Membran ist in diesem Fall vorzugsweise in der schichtweise aufgebauten Leiterplatte einlaminiert und/oder mit dieser verklebt.

Auch ist es vorteilhaft, wenn der erste Leiterplattenhohlraum einen, insbesondere zum zweiten Bereich benachbarten, dritten Bereich, insbesondere einen Membranbeabstandungs- und/oder einen Membranbefestigungsbereich aufweist, durch den die Membran von dem Trägersubstrat beabstandet und/oder in dem die Membran in der Leiterplatte verankert ist. Hierdurch kann die Membran beabstandet vom Trägersubstrat in der Leiterplatte angeordnet werden. Vorzugsweise ist die Membran insbesondere im Bereich des dem zweiten Bereich abgewandten Endes des dritten Bereiches angeordnet, so dass der Abstand zwischen der Membran und dem Trägersubstrat möglichst groß ausgebildet ist. Zur Vergrößerung der Membranfläche ist es ferner vorteilhaft, wenn der erste Leiterplattenhohlraum in seinem dritten Bereich breiter ausgebildet ist als in seinem zweiten Bereich. Hierdurch kann zur Materialeinsparung das Trägersubstrat möglichst klein und zur Erhöhung der akustischen Leistungsfähigkeit des MEMS-Lautsprechers die Membran möglichst groß ausgebildet werden.

Der dritte Bereich kann eine konstante Breite aufweisen. Alternativ dazu kann sich seine Breite aber auch von seinem zum zweiten Bereich benachbarten Ende ausgehend in Richtung der Schallaustrittsöffnung vergrößern.

Vorteilhaft ist es, wenn der erste Leiterplattenhohlraum einen, insbesondere zum dritten Bereich benachbarten, vierten Bereich, insbesondere einen Schallleitkanalbereich, aufweist, dessen Breite sich vorzugsweise vom dritten Bereich ausgehend in Richtung der Schallaustrittsöffnung, insbesondere konisch, vergrößert. Hierdurch kann der Schalldruck des MEMS-Lautsprechers vergrößert werden.

Des Weiteren ist es vorteilhaft, wenn die Membran durch den vierten Bereich von der Außenfläche der Leiterplatte und/oder von der Schallaustrittsöffnung beabstandet ist. Die Membran ist somit geschützt im Inneren der Leiterplatte aufgenommen.

Um die akustische Leistungsfähigkeit des MEMS-Lautsprechers verbessern zu können und diesen zugleich möglichst kostengünstig herstellen zu können, ist es vorteilhaft, wenn die Membran in einer Querschnittsansicht des MEMS-Lautsprechers im Vergleich zur Aktuatorstruktur und/oder zum Trägersubstrat breiter ausgebildet ist.

Auch ist es vorteilhaft, wenn der Zwischenhohlraum durch den Substrathohlraum und/oder zumindest teilweise durch den zweiten und/oder dritten Bereich des ersten Leiterplattenhohlraums ausgebildet ist. Demnach ist es vorteilhaft, wenn das Trägersubstrat mit der Aktuatorstruktur in der Leiterplatte derart angeordnet ist, dass die Aktuatorstruktur benachbart zur Kavität angeordnet ist. In diesem Fall ist der Zwischenhohlraum sowohl durch den Substrathohlraum als auch durch den zweiten und/oder dritten Bereich des ersten Leiterplattenhohlraums ausgebildet. Alternativ dazu kann das Trägersubstrat mit der Aktuatorstruktur aber auch in einer dazu um 180° gedrehten Einbaulage in der Leiterplatte angeordnet sein. In diesem Fall zeigt die Au-ßenfläche der Aktuatorstruktur in Richtung des dritten Bereiches des ersten Leiterplattenhohlraums, so dass der Zwischenhohlraum nicht zusätzlich durch den Substrathohlraum gebildet wird. Der Zwischenhohlraum ist somit ausschließlich durch den zweiten und/oder dritten Bereich des ersten Leiterplattenhohlraums ausgebildet. Bei dieser Einbaulage kann vorteilhafterweise die Größe der Kavität durch den Substrathohlraum vergrößert werden.

Das Koppelelement kann vorteilhafterweise sehr schnell und kostengünstig aus einem Substratrohling zusammen mit dem Trägersubstrat ausgebildet werden. Hierbei wird in den Substratrohling der Substrathohlraum eingebracht, insbesondere geätzt, wodurch zeitgleich sowohl zumindest teilweise das Koppelelement als auch das Trägersubstrat, bzw. der Trägerrahmen, ausgebildet werden.

Das Koppelelement ist mehrteilig ausgebildet. Das Koppelelement umfasst zumindest einen mit der Aktuatorstruktur verbundenen ersten Teil, insbesondere aus Silizium, und einen mit der Membran verbundenen zweiten Teil. Die beiden Teile sind fest miteinander verbunden, insbesondere verklebt. Das zweite Teil kann aus demselben Material wie das erste Teil ausgebildet sein. Diesbezüglich ist es insbesondere vorteilhaft, wenn das zweite Teil aus Silizium ausgebildet ist. Alternativ dazu kann das zweite Teil aber ebenso auch aus einem im Vergleich zum ersten Teil anderen Material, insbesondere Keramik, einem Metall, vorzugsweise Aluminium, einer Metalllegierung, insbesondere Aluminiumnitrid, einem Kunststoff und/oder einem Verbundwerkstoff, insbesondere mit Carbonfasern, ausgebildet sein. Des Weiteren ist es herstellungsbedingt vorteilhaft, wenn das erste Teil keine Hinterschneidungen aufweist. Eine funktionsbedingte geometrische Ausgestaltung des Koppelelementes, beispielsweise mit einer Hinterschneidung - so dass das Koppelelement an seinem der Membran zugewandten Ende eine möglichst gro-ße Kontaktfläche mit der Membran aufweist - kann dem Koppelelement insbesondere mittels des zweiten Teils zugeordnet werden. Hierbei ist es vorteilhaft, wenn der zweite Teil breiter ausgebildet ist als der erste Teil, so dass das Koppelelement eine hinter Schneider aufweist. Alternativ dazu kann der zweite Teil aber auch ebenso eine Hinterschneidung aufweisen, wobei dieses vorzugsweise T-förmig ausgebildet ist.

Da die Membran sehr elastisch ausgebildet ist, ist es zur Vermeidung einer Beschädigung der Membran durch das Koppelelement vorteilhaft, wenn das Koppelelement möglichst großflächig mit der Membran gekoppelt ist. Das Koppelelement ist in einem ersten Verbindungsbereich mit der Aktuatorstruktur und in einem, insbesondere diesem gegenüberliegenden, zweiten Verbindungsbereich mit der Membran verbunden, wobei vorzugsweise der zweite Verbindungsbereich größer, insbesondere in einer Querschnittsansicht des MEMS-Lautsprechers breiter, oder gleich dem ersten Verbindungsbereich ausgebildet ist. Hierdurch kann die vom Aktuator eingebrachte Kraft zum Ansteuern der Membran über das Koppelelement großflächig auf die Membran übertragen werden.

Aus vorstehend genannten Gründen ist es ferner vorteilhaft, wenn das Koppelelement an seinem der Membran zugewandten Ende, insbesondere das zweite Teil, breiter als an seinem der Aktuatorstruktur zugewandten Ende, insbesondere als das erste Teil, ausgebildet ist. Vorzugsweise weist das Koppelelement eine T-Form auf. Zur Ausbildung dieser geometrischen Form kann insbesondere das zweite Teil breiter ausgebildet sein als das erste Teil. Aus herstellungstechnischen Gründen ist es ferner vorteilhaft, wenn das zweite Teil T-förmig ausgebildet ist und/oder das erste Teil im Querschnitt im Wesentlichen quadratisch und/oder rechteckig ausgebildet ist.

Des Weiteren ist es vorteilhaft, wenn das Koppelelement an einer dem Substrathohlraum zugewandten Seite der Aktuatorstruktur befestigt ist. Hierbei kann die Verbindung zwischen dem Koppelelement und der Aktuatorstruktur bereits beim Herstellungsprozess des Trägersubstrats ausgebildet werden, wobei die Aktuatorstruktur vorzugsweise auf den Substratrohling aufgebracht wird und nachträglich der Substrathohlraum eingeätzt wird, wodurch das mit der Aktuatorstruktur verbundene Koppelelement entsteht. Alternativ dazu ist es ebenso vorteilhaft, wenn das Koppelelement an einer dem Substrathohlraum abgewandten Seite der Aktuatorstruktur befestigt ist. In diesem Fall wird das Koppelelement nicht gleichzeitig beim Herstellungsprozess des Trägersubstrats und der Aktuatorstruktur hergestellt, sondern nachträglich auf der Außenseite der Aktuatorstruktur aufgebracht und/oder befestigt. Je nach Anordnung des Koppelelementes relativ zur Aktuatorstruktur kann die Einbauorientierung des Trägersubstrats mit der Aktuatorstruktur variiert werden. Grundsätzlich ist es jedoch vorgesehen, dass sich das Koppelelement von der Aktuatorstruktur ausgehend stets in Richtung der Schallaustrittsöffnung der Leiterplatte erstreckt.

Vorteilhaft ist es, wenn das Koppelelement im Vergleich zum Trägersubstrat in einer Querschnittsansicht des MEMS-Lautsprechers höher ausgebildet ist. Hierdurch kann die Membran bei einer zur Aktuatorstruktur parallelen Ausrichtung vom Trägersubstrat beabstandet angeordnet werden. Infolgedessen ist der Gestaltungsfreiraum bei der Ausbildung der Membran nicht an die geometrischen Ausmaße des Trägersubstrats beschränkt. Die Membran kann somit im Vergleich zur Aktuatorstruktur und/oder zum Trägersubstrat größer bzw. im Querschnitt breiter ausgebildet werden.

In einer vorteilhaften Weiterbildung der Erfindung ist das Trägersubstrat und zumindest teilweise das Koppelelement, insbesondere dessen erster Teil, aus dem gleichen Material, insbesondere aus Silizium, und/oder aus dem gleichen Substratrohling hergestellt. Zusätzlich oder alternativ ist es ferner vorteilhaft, wenn das Trägersubstrat an seiner der Aktuatorstruktur abgewandten Seite ausgespart ist und/oder dickenreduziert ist, so dass das Koppelelement eine größere Höhe aufweist. Hierdurch kann, wie bereits vorstehend ausgeführt, eine Entkopplung zwischen Membran und Trägersubstrat bewirkt werden, so dass die Membran im Vergleich zum Trägersubstrat insbesondere größer ausgebildet werden kann.

Der MEMS-Lautsprecher kann sehr kompakt ausgebildet werden, wenn die Leiterplatte einen, insbesondere vom ersten getrennten, zweiten Leiterplattenhohlraum aufweist, in dem ein ASIC zum Ansteuern der Aktuatorstruktur angeordnet ist, wobei der ASIC hierdurch vorzugsweise vollständig in der Leiterplatte integriert ist.

Zur Ausbildung des ersten und/oder zweiten Leiterplattenhohlraums und/oder zur formschlüssigen Befestigung des Trägersubstrats und/oder der Membran ist es vorteilhaft, wenn die Leiterplatte aus mehreren Schichten ausgebildet ist, die miteinander fest verbunden, insbesondere verklebt, sind.

Weitere Vorteile der Erfindung sind in den nachfolgenden Beispielen beschrieben. Die in den Abbildungen 1-3 sowie 6 gezeigten MEMS-Lautsprecher sind nicht gemäss der vorliegenden Erfindung und dienen lediglich dem Verständnis der Erfindung. Es zeigt:
- **Figur 1**: eine schematische Querschnittsansicht eines MEMS-Lautsprechers mit einer an einem Trägersubstrat befestigter Membran, die mittels eines Koppelelementes mit einer Aktuatorstruktur verbunden ist,
- **Figur 2**: eine schematische Querschnittsansicht des MEMS-Lautsprechers gemäß dem in Figur 1 dargestellten Beispiel, der in eine Leiterplatte integriert ist,
- **Figur 3**: eine schematische Querschnittsansicht des MEMS-Lautsprechers gemäß einem zweiten Beispiel, wobei die Membran vom Trägersubstrat beabstandet in der Leiterplatte verankert und mittels des Koppelelementes mit der Aktuatorschicht verbunden ist,
- **Figur 4**: eine schematische Schnittansicht des MEMS-Lautsprechers mit in der Leiterplatte aufgehängter Membran, wobei das die Membran mit einer Aktuatorstruktur verbindendes Koppelelement zweiteilig ausgebildet ist,
- **Figur 5**: eine schematische Schnittansicht eines weiteren Ausführungsbeispiels des MEMS-Lautsprechers, wobei das mit der Membran verbundene Teil des Koppelelementes T-Form ausgebildet ist,
- **Figur 6**: eine schematische Schnittansicht des MEMS-Lautsprechers gemäß einem weiteren Beispiel, wobei die Einheit aus Trägersubstrat und Aktuatorstruktur im Vergleich zu den vorstehenden Ausführungsbeispielen um 180° gedreht in der Leiterplatte eingebaut ist und das Koppelelement an der Außenseite der Aktuatorstruktur befestigt ist, und
- **Figur 7**: eine schematische Schnittansicht eines weiteren Ausführungsbeispiels des MEMS-Lautsprechers, wobei die Membran an der Außenseite, insbesondere einer Stirnseite, der Leiterplatte befestigt ist.

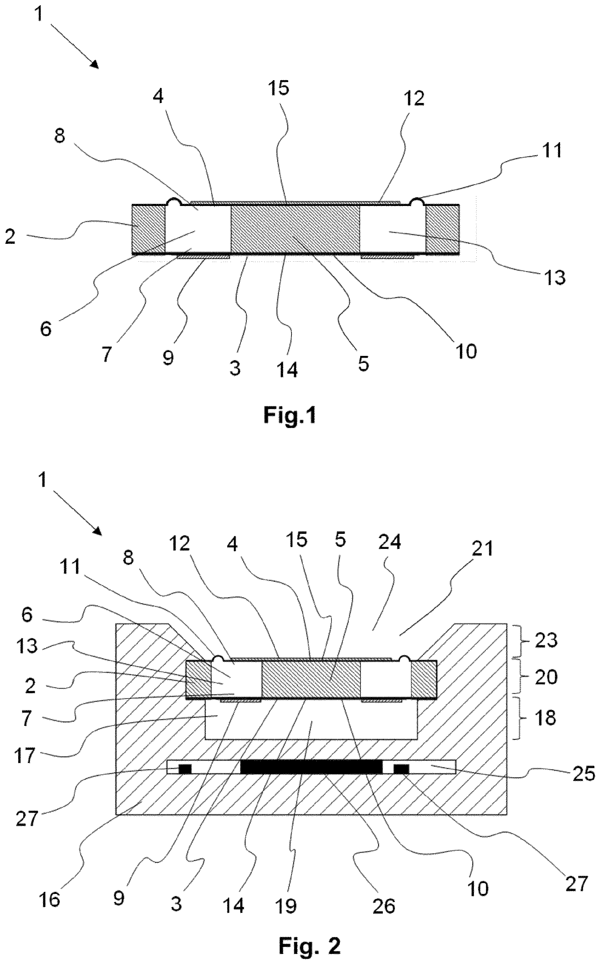

Figur 1 zeigt eine Querschnittsansicht eines ersten Beispiels eines MEMS-Lautsprechers 1. Der MEMS-Lautsprecher 1 weist ein Trägersubstrat 2, eine Aktuatorstruktur 3, eine Membran 4 und ein Koppelelement 5 auf. Gemäß dem vorliegenden Ausführungsbeispiel ist das Trägersubstrat 2 und das Koppelelement 5 zusammen aus einem Substratrohling hergestellt. Das Trägersubstrat 2 weist einen Substrathohlraum 6 auf. Der Substrathohlraum 6 ist an zwei gegenüberliegenden Seiten offen, so dass das Trägersubstrat 2 einen Trägerrahmen ausbildet. Demnach umfasst das Trägersubstrat 2 eine erste Substratöffnung 7 und eine zweite Substratöffnung 8, die an zwei gegenüberliegenden Seiten, insbesondere Stirnseiten, des Trägersubstrats 2 ausgebildet sind. Im Bereich der ersten Substratöffnung 7 ist die Aktuatorstruktur 3 angeordnet.

Die Aktuatorstruktur 3 ist vorzugsweise als piezoelektrische Aktuatorstruktur 3 ausgebildet und umfasst zumindest eine, insbesondere piezoelektrische, Aktuatorschicht 9. Des Weiteren umfasst die sandwichartig aufgebaute Aktuatorstruktur 3 eine Tragschicht 10 sowie zumindest eine hier nicht weiter im Detail dargestellte Elektrodenschicht. Die Aktuatorstruktur 3 überspannt die erste Substratöffnung 7 des Substrathohlraums 6 und ist in ihrem Randbereich mit dem Trägersubstrat 2 verbunden, wobei die Aktuatorstruktur 3 gemäß dem vorliegenden Ausführungsbeispiel vorzugsweise an einer Stirnseite des Trägersubstrats 2 angeordnet ist.

Gemäß dem in Figur 1 dargestellten Beispiel ist die Membran 4 am Trägersubstrat 2 schwingbaren aufgehängt. Die Membran 4 ist in ihrem Randbereich an einer der Aktuatorstruktur 3 gegenüberliegenden Stirnseite des Trägersubstrats 2 befestigt. Vorzugsweise ist die Membran 4 mit dem Trägersubstrat 2 in diesem Bereich verklebt. Die Membran 4 ist sehr flexibel ausgebildet. Sie weist vorzugsweise eine Dicke von weniger als 0,3 mm auf. Des Weiteren weist sie ein E-Modul von weniger als 100 MPa auf. Benachbart zu ihrem Befestigungsbereich weist die Membran 4 des Weiteren zumindest eine Erhebung 11 auf. Mittels dieser Erhebung 11 kann die Elongation der Membran 4 erhöht werden. Dadurch, dass die Membran 4 sehr flexibel ausgebildet ist, kann diese bei einer Überbeanspruchung leicht beschädigt werden. Aufgrund dessen umfasst die Membran 4 gemäß dem in Figur 1 dargestellten Beispiel ein Verstärkungselement 12. Das Verstärkungselement 12 ist an der Außenseite der Membran 4, d.h. an der dem Substrathohlraum 6 abgewandten Seite der Membran 4, befestigt, insbesondere verklebt. Das Verstärkungselement besteht vorzugsweise aus einem Metall, Keramik, Silizium, Kunststoff und/oder aus einem Verbundwerkstoff, insbesondere aus Carbon. Das Verstärkungselement 12 kann vorzugsweise auch aus Aluminium oder Aluminiumnitrid bestehen. Alternativ oder zusätzlich zum Verstärkungselement 12 kann die Membran aber auch ebenso hier nicht dargestellte Verstärkungsbereiche aufweisen, in denen die Membran 4 eine größere dicke, insbesondere mehr als 0,3 mm, aufweist.

Aufgrund der am Trägersubstrat 2 gegenüberliegenden Anordnung der Membran 4 und der Aktuatorstruktur 3 sind diese durch das dazwischen angeordnete Trägersubstrat 2 voneinander beabstandet. Zwischen der Membran 4 und der Aktuatorstruktur 3 ist somit gemäß der in Figur 1 dargestellten Querschnittsansicht des MEMS-Lautsprechers 1 ein Zwischenhohlraum 13 ausgebildet. Gemäß dem in Figur 1 dargestellten Beispiel ist dieser Zwischenhohlraum 13 vollständig durch den Substrathohlraum 6 gebildet. In diesem Zwischenhohlraum 13 ist das Koppelelement 5 angeordnet. In einem ersten Verbindungsbereich 14 ist das Koppelelement 5 mit der Aktuatorstruktur 3, insbesondere an deren Innenseite, verbunden. Des Weiteren weist das Koppelelement 5 einen zweiten Verbindungsbereich 15 auf, in dem das Koppelelement 5 mit der Membran 4 verbunden ist. Aufgrund der am Trägersubstrat 2 stirnseitigen Anordnung der Aktuatorstruktur 3 und der Membran 4 ist das Koppelelement 5 an der dem Trägersubstrat 2 zugewandten Seite, insbesondere an der Innenseite, der Membran 4 befestigt. Das Koppelelement 5 ist mit der Membran 4 in dem zweiten Verbindungsbereich 15 vorzugsweise verklebt. Die Membran 4 ist somit über das Koppelelement 5 derart mit der Aktuatorstruktur 3 gekoppelt, dass die Membran bei einer elektrischen Anregung der Aktuatorschicht 9 zusammen mit dem Koppelelement 5 und der Aktuatorstruktur 3 gegenüber dem Trägersubstrat 2 zu schwingen vermag.

Der MEMS-Lautsprecher 1 ist in den Figuren in seinem inaktiven Zustand dargestellt. In diesem befindet sich die Membran 4, das Koppelelement 5 und/oder die Aktuatorstruktur 3 in einer Neutralstellung, aus der diese bei einer Anregung durch die Aktuatorstruktur 3 ausgelenkt werden können. Die Membran 4 kann vorzugsweise mit einer Elongation von mehr als 200 % ausgelenkt werden. Die Aktuatorstruktur 3 und die Membran 4 sind in der Neutralstellung zueinander parallel ausgerichtet. Die maximale Höhe des Koppelelementes 5 entspricht demnach dem kürzesten Abstand zwischen der Aktuatorstruktur 3 und der Membran 4. Gemäß dem in Figur 1 dargestellten Ausführungsbeispiel ist das Koppelelement 5 genauso hoch ausgebildet wie das Trägersubstrat 2.

Die Aktuatorstruktur 3 wirkt als Spinne eines allgemein bekannten großen Lautsprechers. Die Aktuatorstruktur 3 ist demnach derart ausgebildet, dass sie die Membran 4 in ihrer Neutralstellung mit einer vorbestimmten Kraft hält, so dass die Membran 4 vor einer Beschädigung durch von außen einwirkende Stöße geschützt ist. Des Weiteren wird die akustische Qualität des MEMS-Lautsprechers 1 durch ein entsprechendes Halten der Membran 4 in ihrer Neutralstellung verbessert. So ist die Aktuatorstruktur 3 ferner derart ausgebildet, dass sie die Membran 4 nach ihrer Auslenkung, insbesondere bei inaktiver - d.h. nicht bestromter - Aktuatorstruktur, mittels dieser wieder in ihre Neutralstellung zurückführbar ist.

Figur 2 zeigt einen MEMS-Lautsprecher 1, der eine Leiterplatte 16 umfasst, in die die aus Figur 1 bekannte Einheit eingebettet ist. Die Leiterplatte 16 weist hierfür einen ersten Leiterplattenhohlraum 17 auf. Der erste Leiterplattenhohlraum 17 weist mehrere Bereiche auf. Gemäß dem in Figur 2 dargestellten Ausführungsbeispiel umfasst der erste Leiterplattenhohlraum 17 einen ersten Bereich 18, der eine Kavität 19 des MEMS-Lautsprechers 1 bildet. Des Weiteren umfasst der erste Leiterplattenhohlraum 17 einen zweiten Bereich 20. In diesem zweiten Bereich 20 ist das Trägersubstrat 2 formschlüssig in der Leiterplatte 16 gehalten. Hierfür weist der zweite Bereich 20 eine im Vergleich zum ersten Bereich 18 größere Breite auf, so dass zwischen diesen beiden eine Stufe ausgebildet ist. An dieser Stufe liegt das Trägersubstrat 2 mit seiner der Kavität 19 zugewandten Stirnseite an, so dass der Substratträger 2 formschlüssig in der Leiterplatte 18 gehalten ist. Der zweite Bereich 20 ist unmittelbar benachbart zum ersten Bereich 18 angeordnet.

Auch umfasst der erste Leiterplattenhohlraum 17 einen Schallleitkanal 21, der gemäß dem in Figur 2 dargestellten Beispiel durch einen weiteren Bereich 23 des ersten Leiterplattenhohlraums 17 ausgebildet ist. Der Schallleitkanal 21 bzw. der Bereich 23 ist unmittelbar benachbart zum Trägersubstrat 2 bzw. zum zweiten Bereich 20 des ersten Leiterplattenhohlraums 17 angeordnet.

Die Leiterplatte 16 weist eine Schallaustrittsöffnung 24 auf. Gemäß dem in Figur 2 dargestellten Beispiel ist die Schallaustrittsöffnung 24 am der Membran 4 abgewandten Ende des Schallleitkanals 21 ausgebildet. Der Schallleitkanal 21 ist vorliegend konisch ausgebildet.

Die Leiterplatte 16 weist des Weiteren einen zweiten Leiterplattenhohlraum 25 auf. Dieser ist vom ersten Leiterplattenhohlraum 17 beabstandet und/oder unterhalb von diesem ausgebildet. In dem zweiten Leiterplattenhohlraum 25 ist zumindest ein elektronisches Bauteil, insbesondere ein ASIC 26 angeordnet. Des Weiteren kann auch zumindest ein passives elektronisches Bauteil 27 in dem zweiten Leiterplattenhohlraum 25 angeordnet sein. Zur Ausbildung des ersten und/oder zweiten Leiterplattenhohlraums 17, 25 ist die Leiterplatte 16 schichtweise aufgebaut, wobei zumindest einige dieser Schichten Aussparungen zur Ausbildung des jeweiligen Leiterplattenhohlraums 17, 25 aufweisen.

In den folgenden Figuren sind weitere Beispiele des MEMS-Lautsprechers gezeigt, wobei jeweils im Wesentlichen nur noch auf die Unterschiede in Bezug auf die bereits beschriebenen Ausführungsformen eingegangen wird. So werden bei der nachfolgenden Beschreibung der weiteren Beispiele für gleiche Merkmale gleiche Bezugszeichen verwendet. Sofern diese nicht nochmals detailliert erläutert werden, entspricht deren Ausgestaltung und Wirkweise den vorstehend bereits beschriebenen Merkmalen. Die nachfolgend beschriebenen Unterschiede können mit den Merkmalen der jeweils vorstehenden und nachfolgenden Beispiele kombiniert werden.

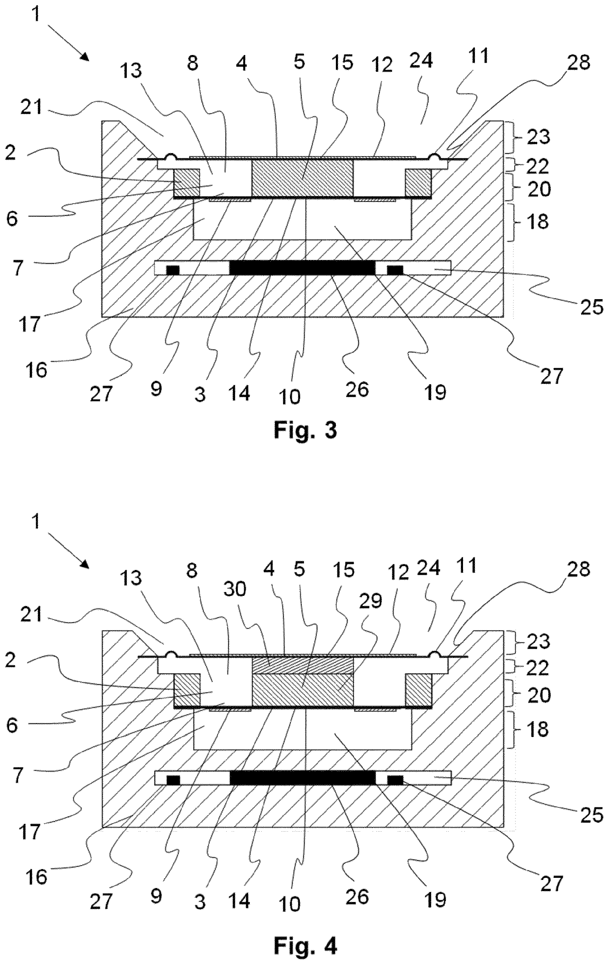

Im Unterschied zu dem in Figur 1 und 2 dargestellten Beispiel ist bei dem in Figur 3 dargestellten Beispiel die Membran 4 vom Trägersubstrat 2 räumlich entkoppelt. Die Membran 4 weist demnach zum Trägersubstrat 2 in der in Figur 3 dargestellten Querschnittsansicht einen Abstand auf. Die Membran 4 ist des Weiteren im Gegensatz zu den vorherigen Beispielen nicht am Trägersubstrat 2 sondern an der Leiterplatte 16 befestigt. So ist die Membran 4 im Inneren des ersten Leiterplattenhohlraums 17 angeordnet und in ihrem Randbereich an einer Seitenwand 28 des ersten Leiterplattenhohlraums 17 befestigt. Gemäß Figur 3 weist der MEMS-Lautsprecher 1 zur Beabstandung der Membran 4 von dem Trägersubstrat 2 einen dritten Bereich 22 auf. Der dritte Bereich 22 (zum vom Trägersubstrat 2 beabstandeten Anordnen der Membran 4) ist benachbart zum zweiten Bereich 20 (zum formschlüssigen Aufnehmen des Trägersubstrats 2) angeordnet. Der dritte Bereich 22 ist im Vergleich zum zweiten Bereich 20 breiter ausgebildet. Infolgedessen weist die Membran 4 im Vergleich zum Trägersubstrat 2 und/oder zur Aktuatorstruktur 3 eine größere Breite auf.

Die Membran 4 erstreckt sich über die gesamte Breite des ersten Leiterplattenhohlraums 17 in die Leiterplatte 16 hinein. Sie ist somit in dieser schwingbar befestigt. Gemäß Figur 3 ist die Membran 4 an dem dem Trägersubstrat 2 abgewandten Ende des dritten Bereiches 22 angeordnet.

In Richtung der Schallaustrittsöffnung 24 schließt sich an den dritten Bereich 22 der vierte Bereich 23 zur Ausbildung des Schallleitkanals 21 an. Die Membran 4 ist in der vorliegend dargestellten Querschnittsansicht des MEMS-Lautsprechers 1 breiter ausgebildet als das Trägersubstrat 2 und die Aktuatorstruktur 3. Aufgrund der Beabstandung der Membran 4 von den Trägersubstrat 2 ist in dem vorliegenden Beispiel der Zwischenhohlraum 13 nunmehr nicht wie bei den vorherigen Beispielen alleinig durch den Substrathohlraum 6 ausgebildet, sondern zusätzlich auch noch durch den dritten Bereich 22 des ersten Leiterplattenhohlraums 17.

Gemäß Figur 3 weist das Koppelelement 5 im Vergleich zum Trägersubstrat 2 eine größere Höhe auf. Das Koppelelement 5 erstreckt sich von der Innenseite der Aktuatorstruktur 3 ausgehend in Richtung der Membran 4 über den zweiten und dritten Bereich 20, 22 des ersten Leiterplattenhohlraums 17. Das Trägersubstrat 2 und das Koppelelement 5 sind wie auch bei den vorherigen

Beispielen aus dem gleichen Material, insbesondere aus Silizium, hergestellt, wobei in einen Substratrohling der Substrathohlraum 6 eingebracht wurde. Im Unterschied zu den vorherigen Beispielen ist jedoch die Höhe des Substratrohlings im Bereich des Trägersubstrats 2, insbesondere im Umfang des dritten Bereiches 22, reduziert worden, so dass das Koppelelement 5 im Vergleich zum Trägersubstrat 2 eine größere Höhe aufweist.

Figur 4 zeigt ein weiteres Ausführungsbeispiel des MEMS-Lautsprechers 1 wobei vorliegend als wesentlicher Unterschied im Vergleich zu den vorherigen Beispielen das Koppelelement 5 nicht einteilig, sondern mehrteilig ausgebildet ist. Das Koppelelement 5 umfasst demnach einen ersten Teil 29 und einen zweiten Teil 30. Die beiden Teile 29, 30 sind fest miteinander verbunden. Das erste Teil 29 ist an der Innenseite, d.h. an der dem Substrathohlraum 6 zugewandten Seite der Aktuatorstruktur 3 befestigt. Das zweite Teil 30 ist mit der Membran 4 an einer der Aktuatorstruktur 3 zugewandten Seite der Membran 4 verbunden.

Die beiden Teile 29, 30 können aus unterschiedlichen oder aus gleichen Materialien bestehen. Vorzugsweise besteht das erste Teil 29 aus dem gleichen Material wie das Trägersubstrat 2. Das zweite Teil 30 besteht vorzugsweise aus einen im Vergleich dazu anderen Material, insbesondere Keramik, Metall, Kunststoff und/oder einem Verbundwerkstoff. Des Weiteren kann der zweite Teil aber auch ebenso aus Aluminium, Aluminiumnitrid und/oder Silizium bestehen.

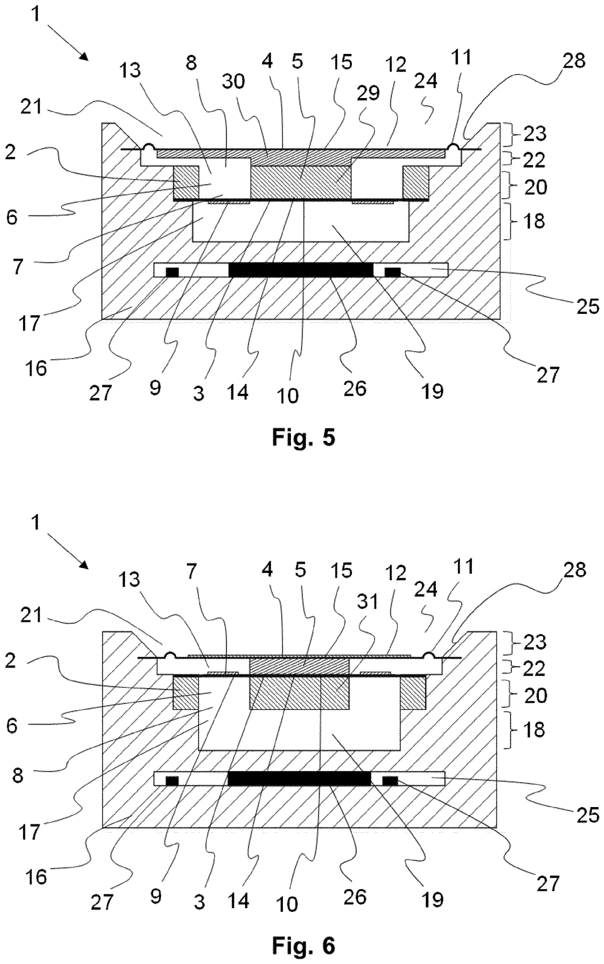

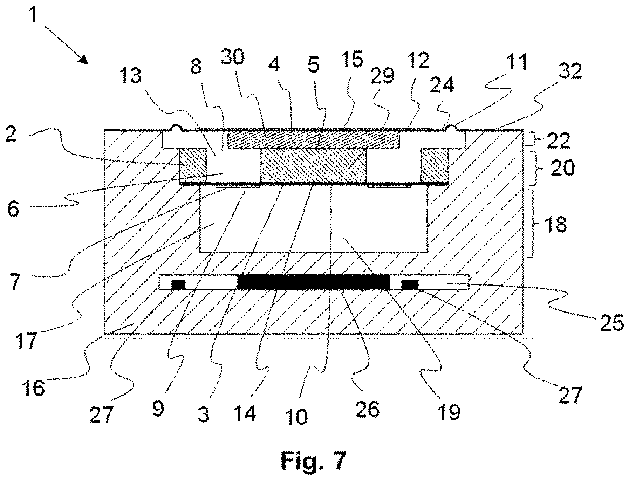

Das Koppelelement 5 ist vorliegend im Querschnitt rechteckig ausgebildet. Das erste und zweite Teil 29, 30 weisen demnach zueinander eine gleiche Breite auf. Alternativ dazu kann das Koppelelement gemäß dem in Figur 5 oder 7 dargestellten Ausführungsbeispiel T-Form ausgebildet sein. Hierdurch ist der erste Verbindungsbereich 14 des Koppelelementes 5 mit der Aktuatorstruktur 3 im Vergleich zum zweiten Verbindungsbereich 15 mit der Membran 4 schmaler ausgebildet. Das Koppelelement 5 weist somit mit der Membran 4 eine größere Verbindungsfläche als mit der Aktuatorstruktur 3 auf. Gemäß Figur 5 und 7 kann das erste Teil 29 des Koppelelementes 5 rechteckig ausgebildet sein. Das zweite Teil 30 des Koppelelementes 5 ist im Gegensatz dazu entweder gemäß Figur 5 T-Form ausgebildet oder weist gemäß Figur 7 eine im Vergleich zum ersten Teil 29 größere Breite auf.

Gemäß dem in Figur 6 dargestellten Beispiel kann die Einheit aus Trägersubstrat 2 und Aktuatorstruktur 3 auch im Unterschied zu den vorherigen Ausführungsbeispielen um 180° gedreht in der Leiterplatte 16 integriert sein. In diesem Fall ist das Koppelelement 5 an einer Außenseite, d.h. an einer dem Substrathohlraum 6 abgewandten Seite der Aktuatorstruktur 3 befestigt. Der Zwischenhohlraum 13 ist somit ausschließlich durch den dritten Bereich 22 des ersten Leiterplattenhohlraums 17 ausgebildet. Des Weiteren ist vorliegend das Koppelelement 5 einteilig ausgebildet. Die Aktuatorstruktur 3 umfasst gemäß dem vorliegenden Beispiel somit zusätzlich ein Versteifungselement 31. Dieses ist an der dem Koppelelement 5 abgewandten Seite der Aktuatorstruktur 3 ausgebildet.

Figur 7 zeigt ein Ausführungsbeispiel des MEMS-Lautsprechers 1 bei dem die Membran 4 nicht im Inneren der Leiterplatte 16 sondern an einer Außenseite, vorliegend insbesondere an einer Stirnseite 32 der Leiterplatte 16 befestigt ist. Die Membran 4 überspannt demnach die Schallaustrittsöffnung 24 der Leiterplatte 16. Des Weiteren ist in Figur 7 eine weitere alternative Ausführung des Koppelelementes 5 gezeigt, wobei das Koppelelement 5 einen im Vergleich zum ersten Verbindungsbereich 14 größeren zweiten Verbindungsbereich 15 aufweist. Das Koppelelementes 5 weist eine T-Form auf, wobei das zweite Teil 30 im Vergleich zum ersten Teil 29 eine größere Breite aufweist.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1.: MEMS-Lautsprecher
- 2.: Trägersubstrat
- 3.: Aktuatorstruktur
- 4.: Membran
- 5.: Koppelelement
- 6.: Substrathohlraum
- 7.: erste Substratöffnung
- 8.: zweite Substratöffnung
- 9.: Aktuatorschicht
- 10.: Tragschicht
- 11.: Erhebung
- 12.: Verstärkungselement
- 13.: Zwischenhohlraum
- 14.: erster Verbindungsbereich
- 15.: zweiter Verbindungsbereich
- 16.: Leiterplatte
- 17.: erster Leiterplattenhohlraum
- 18.: erster Bereich
- 19.: Kavität
- 20.: zweiter Bereich
- 21.: Schallleitkanal
- 22.: dritter Bereich
- 23.: vierter Bereich
- 24.: Schallaustrittsöffnung
- 25.: zweiter Leiterplattenhohlraum
- 26.: ASIC
- 27.: passives elektronisches Bauteil
- 28.: Seitenwand
- 29.: erstes Teil
- 30.: zweites Teil
- 31.: Versteifungselement
- 32.: Stirnseite

## Patentansprüche

1. MEMS-Lautsprecher (1) zum Erzeugen von Schallwellen im hörbaren Wellenlängenspektrum mit
einem Trägersubstrat (2),
das einen Substrathohlraum (6) mit zwei Substratöffnung (7, 8) aufweist, die an zwei gegenüberliegenden Seiten des Trägersubstrats (2) ausgebildet sind,
einer Aktuatorstruktur (3), welche im Bereich einer der beiden Substratöffnungen (7, 8) angeordnet ist und in ihrem Randbereich mit dem Trägersubstrat (2) verbunden ist, und
einer in ihrem Randbereich verankerten Membran (4), die mittels der Aktuatorstruktur (3) zum Erzeugen von Schallwellen in Schwingung versetzbar ist,
**dadurch gekennzeichnet,**
**dass** in einer Querschnittsansicht des MEMS-Lautsprechers (1) die Membran (4) von der Aktuatorstruktur (3) beabstandet ist, so dass zwischen diesen beiden ein Zwischenhohlraum (13) ausgebildet ist, und
**dass** der MEMS-Lautsprecher (1) ein in dem Zwischenhohlraum (13) angeordnetes Koppelelement (5) aufweist,
das mehrteilig ausgebildet ist,
das die Aktuatorstruktur (3) mit der Membran (4) verbindet und
das mit der Aktuatorstruktur (3) und der Membran gegenüber dem Trägersubstrat (2) zu schwingen vermag,
wobei das Koppelelement (5) in einem ersten Verbindungsbereich (14) mit der Aktuatorstruktur (3) und in einem zweiten Verbindungsbereich (15) mit der Membran (4) verbunden ist und
wobei das Koppelelement (5) zumindest einen mit der Aktuatorstruktur (3) verbundenen ersten Teil (29) und einen mit der Membran (4) verbundenen zweiten Teil (30) umfasst und
die beiden Teile (29, 30) fest miteinander verbunden sind.

2. MEMS-Lautsprecher nach dem vorherigen Anspruch, **dadurch gekennzeichnet, dass** die Membran (4) einen verdickten Verstärkungsbereich und/oder ein Verstärkungselement (12) aufweist, das vorzugsweise an ihrer dem Koppelelement (5) abgewandten Seite angeordnet ist.

3. MEMS-Lautsprecher nach einem oder mehreren der vorherigen Ansprüche, **dadurch gekennzeichnet, dass** die Membran (4) im Bereich der anderen Substratöffnung (8) angeordnet ist, diese überspannt und/oder in ihrem Randbereich mit dem Trägersubstrat (2) verbunden ist.

4. MEMS-Lautsprecher nach einem oder mehreren der vorherigen Ansprüche, **dadurch gekennzeichnet, dass** der MEMS-Lautsprecher (1) eine Leiterplatte (16) umfasst, die einen ersten Leiterplattenhohlraum (17) aufweist, in dem das Trägersubstrat (2), die Aktuatorstruktur (3) und die Membran (4) derart angeordnet sind, dass die Aktuatorstruktur (3) und die Membran (4) zu schwingen vermögen.

5. MEMS-Lautsprecher nach dem vorherigen Anspruch, **dadurch gekennzeichnet, dass** der erste Leiterplattenhohlraum (17) einen ersten Bereich (18) aufweist, der zumindest teilweise eine Kavität (19) des MEMS-Lautsprechers ausbildet und
einen zweiten Bereich (20) aufweist, in dem das Trägersubstrat (2) angeordnet ist.

6. MEMS-Lautsprecher nach einem oder mehreren der vorherigen Ansprüche, **dadurch gekennzeichnet, dass** die Membran (4) in einer Querschnittsansicht des MEMS-Lautsprechers vom Trägersubstrat (2) beabstandet ist und vorzugsweise in ihrem Randbereich mit der Leiterplatte (16) verbunden ist.

7. MEMS-Lautsprecher nach dem vorherigen Anspruch 5, **dadurch gekennzeichnet, dass** der erste Leiterplattenhohlraum (17) einen zum zweiten Bereich (20) benachbarten, dritten Bereich (22) aufweist, in dem die Membran (4) angeordnet ist, wobei der erste Leiterplattenhohlraum (17) in einer Querschnittsansicht in seinem dritten Bereich (22) breiter als in seinem zweiten Bereich (20) ausgebildet ist.

8. MEMS-Lautsprecher nach einem oder mehreren der vorherigen Ansprüche, **dadurch gekennzeichnet, dass** die Membran (4) in einer Querschnittsansicht des MEMS-Lautsprechers breiter als die Aktuatorstruktur (3) und/oder das Trägersubstrat (2) ausgebildet ist.

9. MEMS-Lautsprecher nach einem oder mehreren der vorherigen Ansprüche, **dadurch gekennzeichnet, dass** die beiden Teile (29, 30) aus unterschiedlichen Materialien ausgebildet sind.

10. MEMS-Lautsprecher nach einem oder mehreren der vorherigen Ansprüche, **dadurch gekennzeichnet, dass** der zweite Verbindungsbereich (15) größer oder gleich dem ersten Verbindungsbereich (14) ausgebildet ist.

11. MEMS-Lautsprecher nach einem oder mehreren der vorherigen Ansprüche, **dadurch gekennzeichnet, dass** das Koppelelement (5) an seinem der Membran (4) zugewandte Ende, insbesondere das zweite Teil (30), breiter als an seinem der Aktuatorstruktur (3) zugewandten Ende, insbesondere als das erste Teil (29), ausgebildet ist.

12. MEMS-Lautsprecher nach dem vorherigen Anspruch 11, **dadurch gekennzeichnet, dass** das Koppelelement (5), insbesondere der zweite Teil (30), eine T-Form aufweist.

13. MEMS-Lautsprecher nach einem oder mehreren der vorherigen Ansprüche, **dadurch gekennzeichnet, dass** das Trägersubstrat (2) und der erste Teil (29) aus dem gleichen Material, insbesondere aus Silizium, und/oder aus dem gleichen Substratrohling hergestellt sind.

## Claims

1. A MEMS loudspeaker (1) for generating sound waves in the audible wavelength spectrum, comprising:
a carrier substrate (2),
comprising a substrate cavity (6) with two substrate openings (7, 8), which are formed on two opposite sides of the carrier substrate (2),
an actuator structure (3), arranged in the area of one of the two substrate openings (7, 8) and connected in its edge area to the carrier substrate (2), and
a diaphragm (4) anchored in its edge area, which can be set into vibration by means of the actuator structure (3) to generate sound waves,
**characterized in that**
in a cross-sectional view of the MEMS loudspeaker (1), the diaphragm (4) is spaced apart from the actuator structure (3), so that an intermediate cavity (13) is formed between the two, and
the MEMS loudspeaker (1) comprises a coupling element (5) disposed in the intermediate cavity (13),
the coupling element (5) being formed in multiple parts,
the coupling element (5) connects the actuator structure (3) to the diaphragm (4) and
the membrane and the actuator structure (3) are free to vibrate with respect to the carrier substrate (2),
wherein the coupling element (5) is connected to the actuator structure (3) within a first connecting area (14) and to the diaphragm (4) within a second connecting area (15), and
wherein the coupling element (5) includes a first part (29) connected to the actuator structure (3) and a second part (30) connected to the diaphragm (4) and
the two parts (29, 30) are firmly connected to each other.

2. MEMS loudspeaker according to the preceding claim, **characterized in that** the diaphragm (4) comprises a thickened reinforcing area and/or a reinforcing element (12), which is preferably arranged on its side facing away from the coupling element (5).

3. MEMS loudspeaker according to one or several of the preceding claims, **characterized in that** the diaphragm (4) is arranged in the area of the substrate opening (8), overlapping the latter and/or being connected to the carrier substrate (2) in its edge area.

4. MEMS loudspeaker according to one or several of the preceding claims,
**characterized in that**,
the MEMS loudspeaker (1) comprises a circuit board (16), having a first circuit board cavity (17), in which the carrier substrate (2), the actuator structure (3) and the diaphragm (4) are arranged in such a manner that the actuator structure (3) and the diaphragm (4) are able to vibrate.

5. MEMS loudspeaker according to the preceding claim, **characterized in that**, the first circuit board cavity (17) comprises a first area (18), which at least partially defines a cavity (19) of the MEMS loudspeaker and
comprising a second area (20), in which the carrier substrate (2) is arranged.

6. MEMS loudspeaker according to one or several of the preceding claims, **characterized in that**, the diaphragm (4) in a cross-sectional view of the MEMS loudspeaker is spaced at a distance from the carrier substrate (2) and is connected preferably in its edge area to the circuit board (16).

7. MEMS loudspeaker according to claim 5, **characterized in that**, the first circuit board cavity (17) comprises a third area (22), which is adjacent to the second area (20), in which the diaphragm (4) is arranged, wherein the first circuit board cavity (17) is formed to be wider in its third area (22) than in its second area (20) in a cross-sectional view.

8. MEMS loudspeaker according to one or several of the preceding claims, **characterized in that**, in a cross-sectional view of the MEMS loudspeaker, the diaphragm (4) is formed to be wider than the actuator structure (3) and/or the carrier substrate (2).

9. MEMS loudspeaker according to one or several of the preceding claims, **characterized in that**, the two parts (29, 30) are formed from different materials.

10. MEMS loudspeaker according to one or several of the preceding claims, **characterized in that** the second connection area (15) is formed greater than or equal to the first connection area (14).

11. MEMS loudspeaker according to one or several of the preceding claims, **characterized in that** the coupling element (5) is formed wider at its end facing the diaphragm (4), in particular the second part (30), than at its end facing the actuator structure (3), in particular than the first part (29).

12. MEMS loudspeaker according to the preceding claim 11, **characterized in that**, the coupling element (5), in particular the second part (30) has a T-shape.

13. MEMS loudspeaker according to one or several of the preceding claims, **characterized in that** the carrier substrate (2) and the first part (29) are made of the same material, in particular of silicon, and/or of the same substrate blank.

## Revendications

1. Haut-parleur MEMS (1) pour générer des ondes acoustiques dans le spectre de longueurs d'onde audible
avec un substrat support (2),
qui présente une cavité de substrat (6) avec deux ouvertures de substrat (7, 8) qui sont réalisées sur deux côtés opposés du substrat support (2),
une structure d'actionneur (3) qui est disposée dans la zone de l'une des deux ouvertures de substrat (7, 8) et est reliée dans sa zone de bord au substrat support (2), et
une membrane (4) ancrée dans sa zone de bord, qui peut être mise en oscillation au moyen de la structure d'actionneur (3) pour générer des ondes acoustiques,
**caractérisé en ce que**
dans une vue en section transversale du haut-parleur MEMS (1), la membrane (4) est espacée de la structure d'actionneur (3) de sorte qu'une cavité intermédiaire (13) est réalisée entre ces deux, et
le haut-parleur MEMS (1) présente un élément de couplage (5) disposé dans la cavité intermédiaire (13),
qui est réalisé en plusieurs parties,
qui relie la structure d'actionneur (3) à la membrane (4) et
qui peut osciller avec la structure d'actionneur (3) et la membrane par rapport au substrat support (2),
dans lequel l'élément de couplage (5) est relié dans une première zone de liaison (14) à la structure d'actionneur (3) et dans une deuxième zone de liaison (15) à la membrane (4) et
dans lequel l'élément de couplage (5) comprend au moins une première partie (29) reliée à la structure d'actionneur (3) et une deuxième partie (30) reliée à la membrane (4) et
les deux parties (29, 30) sont reliées fixement l'une à l'autre.

2. Haut-parleur MEMS selon la revendication précédente, **caractérisé en ce que** la membrane (4) présente une zone de renforcement épaissie et/ou un élément de renforcement (12) qui est disposé de préférence sur son côté opposé à l'élément de couplage (5).

3. Haut-parleur MEMS selon l'une ou plusieurs des revendications précédentes, **caractérisé en ce que** la membrane (4) est disposée dans la zone de l'autre ouverture de substrat (8), recouvre celle-ci et/ou est reliée dans sa zone de bord au substrat support (2).

4. Haut-parleur MEMS selon l'une ou plusieurs des revendications précédentes, **caractérisé en ce que** le haut-parleur MEMS (1) comprend une carte de circuit imprimé (16) qui présente une première cavité de carte de circuit imprimé (17) dans laquelle le substrat support (2), la structure d'actionneur (3) et la membrane (4) sont disposés de telle sorte que la structure d'actionneur (3) et la membrane (4) peuvent osciller.

5. Haut-parleur MEMS selon la revendication précédente, **caractérisé en ce que** la première cavité de carte de circuit imprimé (17) présente une première zone (18) qui forme au moins partiellement une cavité (19) du haut-parleur MEMS et présente une deuxième zone (20) dans laquelle le substrat support (2) est disposé.

6. Haut-parleur MEMS selon l'une ou plusieurs des revendications précédentes, **caractérisé en ce que** la membrane (4) est espacée du substrat support (2) dans une vue en section transversale du haut-parleur MEMS et est reliée de préférence dans sa zone de bord à la carte de circuit imprimé (16).

7. Haut-parleur MEMS selon la revendication précédente 5, **caractérisé en ce que** la première cavité de carte de circuit imprimé (17) présente une troisième zone (22) adjacente à la deuxième zone (20), dans laquelle la membrane (4) est disposée, dans lequel la première cavité de carte de circuit imprimé (17) est réalisée dans une vue en section transversale plus large dans sa troisième zone (22) que dans sa deuxième zone (20).

8. Haut-parleur MEMS selon l'une ou plusieurs des revendications précédentes, **caractérisé en ce que** la membrane (4) est réalisée dans une vue en section transversale du haut-parleur MEMS plus large que la structure d'actionneur (3) et/ou le substrat support (2).

9. Haut-parleur MEMS selon l'une ou plusieurs des revendications précédentes, **caractérisé en ce que** les deux parties (29, 30) sont réalisées à partir de matériaux différents.

10. Haut-parleur MEMS selon l'une ou plusieurs des revendications précédentes, **caractérisé en ce que** la deuxième zone de liaison (15) est réalisée plus grande ou égale à la première zone de liaison (14).

11. Haut-parleur MEMS selon l'une ou plusieurs des revendications précédentes, **caractérisé en ce que** l'élément de couplage (5) est réalisé à son extrémité tournée vers la membrane (4), en particulier la deuxième partie (30), plus large qu'à son extrémité tournée vers la structure d'actionneur (3), en particulier que la première partie (29).

12. Haut-parleur MEMS selon la revendication précédente 11, **caractérisé en ce que** l'élément de couplage (5), en particulier la deuxième partie (30), présente une forme en T.

13. Haut-parleur MEMS selon l'une ou plusieurs des revendications précédentes, **caractérisé en ce que** le substrat support (2) et la première partie (29) sont fabriqués à partir du même matériau, en particulier à partir de silicium, et/ou à partir de la même ébauche de substrat.
